# EUROPEAN PATENT SPECIFICATION

(11) **EP 2 172 983 B1**
(45) Date of publication and mention of the grant of the patent: **19.11.2014**
(21) Application number: 08790571.7
(22) Date of filing: 24.06.2008
(51) Int. Cl.: H01L 33/50, C09K 11/64, C09K 11/73

(54) **LIGHT EMITTING DEVICE**
LICHTEMITTIERENDE VORRICHTUNG
DISPOSITIF ÉLECTROLUMINESCENT

(30) Priority: 19.07.2007 JP 2007188349
(43) Date of publication of application: 07.04.2010
(73) Proprietor: Sharp Kabushiki Kaisha, Osaka-shi, Osaka 545-8522 (JP)
(72) Inventor: MASUDA, Masatsugu, Osaka-shi, Osaka 545-8522 (JP); TERASHIMA, Kenji, Osaka-shi, Osaka 545-8522 (JP)
(74) Representative: Treeby, Philip David William
(86) International application number: PCT/JP2008/061432
(87) International publication number: WO 2009/011205

(56) References cited:
- EP-A1- 1 670 070
- EP-A1- 1 749 074
- EP-A2- 1 710 291
- WO-A1-2005/083036
- WO-A1-2006/101095
- WO-A1-2007/040107
- WO-A1-2007/062137
- JP-A- 2005 286 312
- JP-A- 2006 049 799
- JP-A- 2006 137 946
- JP-A- 2007 134 656
- JP-A- 2007 134 656
- US-A1- 2005 189 863
- US-A1- 2007 108 896
- YINGXUE ZHOU: "VUV spectrum of Eu2+ doped halophosphates", MATERIALS SCIENCE AND ENGINEERING, vol. 68, no. 1, 6 December 1999 (1999-12-06), pages 48-51, XP002640431, Amsterdam DOI: 10.1016/S0921-5107(99)00334-7
- R. JAGANNATHAN: "Anomalous fluorescence features of Eu2+ in apatite - pyromorphite type matrices", JOURNAL OF LUMINESCENCE, vol. 71, no. 2, 15 May 1998 (1998-05-15), pages 115-121, XP002640623, usa DOI: 10.1016/S0022-2313(96)00127-5
- LI LAN ET AL: "Luminescent research of Sr5(PO4)3Cl:Eu<2+> blue phosphor used for electron beam excitation", CHINESE SCIENCE BULLETIN, SCIENCE PRES, BEIJING, CN, vol. 48, no. 15, 1 August 2003 (2003-08-01), pages 1558-1560, XP008137670, ISSN: 1001-6538, DOI: DOI:10.1360/02WB0191

## Description

### TECHNICAL FIELD

The present invention relates to a light emitting apparatus with highly excellent reliability.

### BACKGROUND ART

A light emitting apparatus having a semiconductor light emitting element and a phosphor in combination has been attracting attention and being studied and developed actively, as such a light emitting apparatus is considered as a next-generation light emitting apparatus whose low power consumption, compact size, high luminance, and high color gamut, as well as high color rendition are expected to be achieved. As the primary light to be emitted from the light emitting element, usually the light in a range from the longer ultraviolet to the visible blue, namely from 380 to 480 nm is used. Further, a light converter employing various phosphors appropriate for this use has been proposed.

Furthermore, for the light emitting apparatus of this type, an attempt has recently been made not only to improve luminous efficiency (brightness) but also to increase input energy to achieve higher brightness. If the input energy is increased, efficient heat dissipation of the entire light emitting apparatus including the light converter is required. In view of this, the structure and material for example of the whole light emitting apparatus are being developed. Currently, however, a temperature rise of the light emitting element and the light converter during operation is unavoidable. Further, the resistance to and the chemical stability under the longer ultraviolet light or visible blue light used as the primary light are important factors.

In a current white light emitting apparatus, a combination of a blue-emission light emitting element (peak wavelength: around 450 nm) and a trivalent cerium activated (Y, Gd)₃(Al, Ga)₅O₁₂ phosphor or divalent europium activated 2(Sr, Ba, Ca)O SiO₂ phosphor excited by the blue light to emit yellow light is mainly used.

Particularly the divalent europium activated 2(Sr, Ba, Ca)O SiO₂ phosphor (disclosed for example in U. S. Patent No. 6,809,347 (Patent Document 1) and U.S. Patent No. 6,943,380 (Patent Document 2)), however, is highly hygroscopic (highly soluble in water), and is thus accompanied by a technical problem that the phosphor chemically reacts with moisture in a resin when the light emitting apparatus is operated for a long period of time, resulting in considerable deterioration in properties. It is therefore imperative to improve the chemical stability of a phosphor used for the light emitting apparatus of this type.

Regarding the light emitting apparatus of this type, Japanese Patent Laying-Open No. 2002-60747 (Patent Document 3) for example discloses that SrGa₂S₄:Eu²⁺ and SrS:Eu²⁺ are chiefly used as a green phosphor and a red phosphor respectively for improving the color rendering property. Thiogallate and sulfide, however, are chemically unstable. In particular, sulfide has a property of being likely to decompose when irradiated with ultraviolet light.

Further, Japanese National Patent Publication No. 11-500584 (Patent Document 4) for example discloses that at least one rare earth doped thiogallate or rare earth doped aluminate or rare earth doped orthosilicate is used for a luminous substance pigment powder. Thiogallate, however, is chemically unstable as described above, and is thus accompanied by a technical problem that free S reacts with a metal to significantly deteriorate the properties of the light emitting apparatus.

Furthermore, U.S. Patent No. 6,812,500 (Patent Document 5) for example discloses, as an inorganic luminescence material, at least one selected from garnets doped with rare earths, alkaline earth metal sulfides doped with rare earths, thiogallates doped with rare earths, aluminates doped with rare earths, and orthosilicates doped with rare earths. Thiogallate, however, is chemically unstable, and free S reacts with a metal to significantly deteriorate the properties of the light emitting apparatus as described

Furthermore, U.S. Patent No. 6,812,500 (Patent Document 5) for example discloses, as an inorganic luminescence material, at least one selected from garnets doped with rare earths, alkaline earth metal sulfides doped with rare earths, thiogallates doped with rare earths, aluminates doped with rare earths, and orthosilicates doped with rare earths. Thiogallate, however, is chemically unstable, and free S reacts with a metal to significantly deteriorate the properties of the light emitting apparatus as described above. Further, sulfide is also chemically unstable and accordingly accompanied by a technical problem that sulfide has a property of being likely to decompose when irradiated with ultraviolet light.

EP 1,710,291 discloses a light-emitting device comprises a semiconductor light-emitting element that emits blue-violet or blue light and a fluorescent material that absorbs all or a part of the light emitted by the semiconductor light-emitting element and emits fluorescence of wavelengths different from that of the light, wherein the fluorescent material comprises a mixture of a first fluorescent material that emits green or yellow-green light, a second fluorescent material that has a longer emission wavelength than that of the first fluorescent material and emits yellow-green, yellow, or yellow-red light, and a third fluorescent material that has a longer emission wavelength than the second fluorescent material and emits yellow-red or red light.

JP 2007-134656 discloses a fluorescent device which can obtain white light of high color rendering and can elevate a light output efficiency of white light, and to provide a light emitting device having it. The fluorescent board is a board member for converting wavelength which is located on the light output side of an LED element; and where three kinds of fluorescent layers emitting wavelength converted light of red light, green light, and blue light respectively, excited by light emitted from the LED element are laminated along the light output side from the light emitting element side.
Patent Document 1: U.S. Patent No. 6,809,347
Patent Document 2: U.S. Patent No. 6,943,380
Patent Document 3: Japanese Patent Laying-Open No. 2002-60747
Patent Document 4: Japanese National Patent Publication No. 11-500584
Patent Document 5: U.S. Patent No. 6,812,500

### DISCLOSURE OF THE INVENTION

### PROBLEMS TO BE SOLVED BY THE INVENTION

The present invention has been made to solve the problems above, and an object of the invention is to provide a light emitting apparatus with excellent life property, high reliability, high efficiency, and high color rendition or high color gamut (NTSC ratio).

### MEANS FOR SOLVING THE PROBLEMS

The inventors of the present invention have thoroughly examined, studied and explored the above-described technical problems. Consequently the inventors have confirmed through a number of experiments that nitride and oxynitride phosphors are chemically stable and excellent in resistance to and chemical stability under the longer ultraviolet or the visible blue light used as the primary light, and found that a light emitting apparatus having such phosphors used for a light converter is excellent in stability of properties of the light emitting apparatus even while being operated for a long period of time. Specifically, the present invention is as follows.

A light emitting apparatus of the present invention includes a light emitting element, and a light converter absorbing a part of primary light emitted from the light emitting element to emit secondary light having a longer wavelength than that of the primary light, said light converter including a red light emitting phosphor and a green light emitting phosphor, said red light emitting phosphor being a divalent europium activated nitride red light emitting phosphor represented by general formula (A): (MI₁₋ₐEuₐ)MIISiN₃ where MI is at least one element selected from Mg, Ca, Sr, and Ba, MII is at least one element selected from Al, Ga, In, Sc, Y, La, Gd, and Lu, and 0.001 ≤ a ≤ 0.10, and said green light emitting phosphor being a divalent europium activated oxynitride green light emitting phosphor that is β-type SiAlON represented by general formula (B): Eu_{b}Si_{c}Al_{d}OₑN_{f} where 0.005 ≤ b ≤ 0.4, c + d = 12, and e + f = 16; characterized in that the light emitting element is of a gallium nitride based semiconductor, and the method comprising the step; applying a forward current to the light emitting element in a range of 25 to 35 mA, wherein the light emitting apparatus comprises at least two said light emitting elements.

Preferably the primary light emitted from the light emitting element has a peak wavelength of 430 to 480 nm.

Preferably the primary light emitted from the light emitting element has a peak wavelength of 380 to 420 nm, and the light converter further includes a blue light emitting phosphor that is
a divalent europium activated halophosphate blue light emitting phosphor substantially represented by
general formula (E): (MVI, Eu)₁₀(PO₄)₆·Cl₂ (in general formula (E), MVI is at least one element selected from Mg, Ca, Sr, and Ba),
a divalent europium activated aluminate blue light emitting phosphor substantially represented by
general formula (F): p(MVII, Eu)O·qAl₂O₃
(in general formula (F), MVII is at least one element selected from Mg, Ca, Sr, Ba, and Zn, p > 0, q > 0,0.1 ≤ p/q ≤ 1.0), or
a divalent europium and manganese activated aluminate blue light emitting phosphor substantially represented by
general formula (G): p(MVII, Euᵣ, Mnₛ)O·qAl₂O₃
(in general formula (G), MVII is at least one element selected from Mg, Ca, Sr, Ba, and Zn, p > 0, q > 0,0.1 ≤ p/q ≤ 1.0, r > 0, s > 0, and 0.001 < s/r < 0.2).

Preferably, in the light emitting apparatus of the first aspect of the present invention, a divalent europium activated nitride red light emitting phosphor is used that is represented by the above-described general formula (A) where MII is at least one element selected from Al, Ga and In.

Preferred embodiments are set out in the dependent claims.

### EFFECTS OF THE INVENTION

The light emitting apparatus of the present invention can efficiently absorb the light emitted from the light emitting element to produce white light with excellent life property, high reliability, high efficiency, and high color rendition or high color gamut (NTSC ratio).

### BRIEF DESCRIPTION OF THE DRAWINGS

Fig. 1 is a cross section schematically showing a light emitting apparatus 1 in a preferred example of the present invention.
Fig. 2 is a cross section schematically showing a light emitting apparatus 11 in a comparative example.

### DESCRIPTION OF THE REFERENCE SIGNS

1, 11 light emitting apparatus, 2 light emitting element, 3, 12 light converter, 4 red light emitting phosphor, 5 green or yellow light emitting phosphor, 6 sealant, 13 yellow light emitting phosphor

### BEST MODES FOR CARRYING OUT THE INVENTION

The light emitting apparatus of the first aspect of the present invention basically

Preferably, the light emitting apparatus of the first aspect and the light emitting apparatus of the second aspect of the present invention includes at least two light emitting elements.

Preferably, in the light emitting apparatus of the first aspect of the present invention, a divalent europium activated nitride red light emitting phosphor is used that is represented by the above-described general formula (A) where MII is at least one element selected from Al, Ga and In.

Preferably, in the light emitting apparatus of the first aspect and the light emitting apparatus of the second aspect of the present invention, a trivalent cerium activated silicate green light emitting phosphor is used that is represented by the above-described general formula (D) where MV is at least one element selected from Ga, In, Sc, and Y.

### EFFECTS OF THE INVENTION

The light emitting apparatus of the present invention can efficiently absorb the light emitted from the light emitting element to produce white light with excellent life property, high reliability, high efficiency, and high color rendition or high color gamut (NTSC ratio).

### BRIEF DESCRIPTION OF THE DRAWINGS

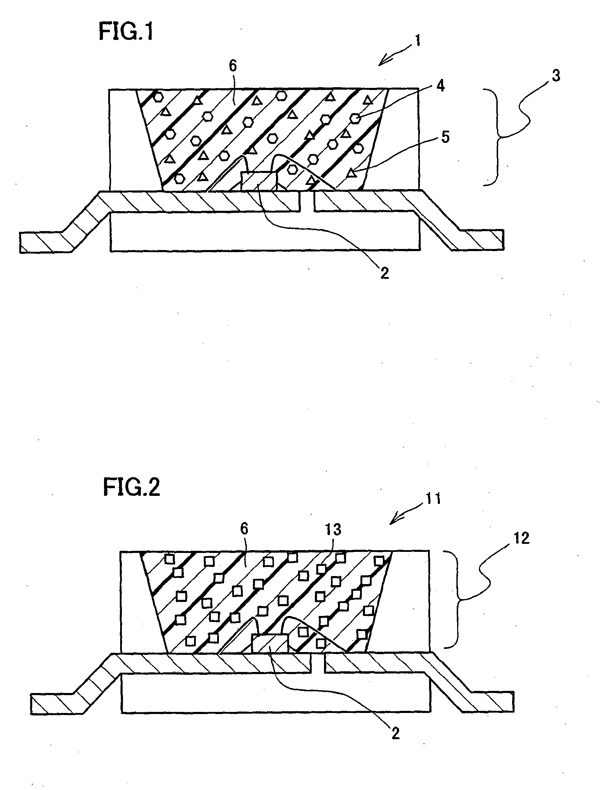

Fig. 1 is a cross section schematically showing a light emitting apparatus 1 in a preferred example of the present invention.
Fig. 2 is a cross section schematically showing a light emitting apparatus 11 in another preferred example of the present invention.

### DESCRIPTION OF THE REFERENCE SIGNS

1, 11 light emitting apparatus, 2 light emitting element, 3, 12 light converter, 4 red light emitting phosphor, 5 green or yellow light emitting phosphor, 6 sealant, 13 yellow light emitting phosphor

### BEST MODES FOR CARRYING OUT THE INVENTION

The light emitting apparatus of the first aspect of the present invention basically includes a light emitting element of a gallium nitride (GaN) based semiconductor, and a light converter absorbing a part of primary light emitted from the light emitting element to emit secondary light with its longer wavelength than that of the primary light. The light converter in the light emitting apparatus of the present invention includes, as a red light emitting phosphor, the following (A) a divalent europium activated nitride red light emitting phosphor and, as a green light emitting phosphor, the following (B) a divalent europium activated oxynitride green light emitting phosphor that is β-type SiAlON. In a comparative example a green or yellow light emitting phosphor may be used, such as (C) a divalent europium activated oxynitride yellow light emitting phosphor that is α-type SiAlON, or (D) a trivalent cerium activated silicate green light emitting phosphor.

### (A) Divalent europium activated nitride red light emitting phosphor

The divalent europium activated nitride red light emitting phosphor is substantially represented by general formula (A): (MI₁₋ₐEuₐ)MIISiN₃.

In general formula (A), MI is at least one element selected from Mg (magnesium), Ca (calcium), Sr (strontium), and Ba (barium). In general formula (A), MII is at least one element selected from Al (aluminum), Ga (gallium), In (indium), Sc (scandium), Y (yttrium), La (lanthanum), Gd (gadolinium), and Lu (lutetium). In particular, in terms of properties, MII is preferably at least one element selected from Al, Ga and In, and Al is most preferable. In general formula (A), Eu represents europium, Si represents silicon and N represents nitrogen.

In general formula (A), a value of "a" representing the proportion (concentration) ofEu satisfies the relation 0.001 ≤ a ≤ 0.10, which is preferably 0.005 ≤ a ≤ 0.02. If a value of "a" is smaller than 0.001, a sufficient brightness cannot be obtained. If a value of "a" is larger than 0.10, the brightness is considerably deteriorated due to concentration quenching or the like. Specific examples of the divalent europium activated nitride red light emitting phosphor may include, but surely are not limited to, (Ca_{0.99}Eu_{0.01})AlSiN₃, (Ca_{0.96}Sr_{0.03}Eu_{0.01})AlSiN₃, (Ca_{0.99}Eu_{0.01})(Al_{0.95}Ga_{0.05})SiN₃, (Ca_{0.985}Eu_{0.015})(Al_{0.99}In_{0.01})SiN₃, (Ca_{0.985}Eu_{0.015})AlSiN₃, (Ca_{0.99}Eu_{0.01})(Al_{0.99}Ga_{0.01})SiN₃, (Ca_{0.98}Eu_{0.02})AlSiN₃, (Ca_{0.94}Mg_{0.05}Eu_{0.01})(Al_{0.99}In_{0.01})SiN₃, (Ca_{0.94}Mg_{0.05}Eu_{0.01})(Al_{0.99}Ga_{0.01})SiN₃, (Ca_{0.97}Sr_{0.01}Eu_{0.02})(Al_{0.99}Ga_{0.01})SiN₃, (Ca_{o.84}Sr_{0.15}Eu_{0.01})AlSiN₃, (Ca_{0.995}Eu_{0.005})AlSiN₃, (Ca_{0.989}Sr_{0.010}Eu_{0.001})(Al_{0.985}Ga_{0.015})SiN₃, and (Ca_{0.93}Mg_{0.02}Eu_{0.05})AlSiN₃, for example.

While the average particle size of the divalent europium activated nitride red light emitting phosphor is not limited to a particular one, the average particle size measured by Blaine's method is preferably in a range of 3 to 10 µm, and more preferably in a range of 4 to 7 µm. If the average particle size of the red light emitting phosphor is smaller than 3 µm, crystal growth is insufficient and the brightness could be considerably deteriorated. If the average particle size of the red light emitting phosphor is larger than 10 µm, an abnormally grown large particle is likely to be generated, which is not suitable for practical use.

### (B) Divalent europium activated oxynitride green light emitting phosphor that is β-type SiAlON

The divalent europium activated oxynitride green light emitting phosphor is substantially represented by general formula (B): E_{Ub}Si_{c}Al_{d}OₑN_{f}.

In general formula (B), Eu represents europium, Si represents silicon, Al represents aluminum, O represents oxygen, and N represents nitrogen. In general formula (B), a value of "b" representing the proportion (concentration) ofEu satisfies the relation 0.005 ≤ b ≤ 0.4. If a value of "b" is smaller than 0.005, a sufficient brightness cannot be obtained. If a value of "b" is larger than 0.4, the brightness is considerably deteriorated due to concentration quenching or the like. In terms of powder properties stability and host crystal homogeneity, a value of "b" in the formula above preferably satisfies the relation 0.01 ≤ b ≤ 0.2. In general formula (B), respective numerical values of "c" representing the proportion (concentration) of Si and "d" representing the proportion (concentration) of Al satisfy the relation c + d = 12, and respective numerical values of "e" representing the proportion (concentration) of O and "f' representing the proportion (concentration) of N satisfy the relation e + f = 16.

Specific examples of the divalent europium activated oxynitride green light emitting phosphor that is β-type SiAlON may include, but surely are not limited to, Eu_{0.01}Si_{11.80}Al_{0.20}O_{0.04}N_{15.96}, Eu_{0.05}Si_{11.50}Al_{0.50}N_{15.95}, Eu_{0.10}Si_{11.00}Al_{1.00}O_{0.10}N_{15.90}, Eu_{0.30}Si_{9.80}Al_{2.20}O_{0.30}N_{15.70}, Eu_{0.15}Si_{10.00}Al_{2.00}O_{0.20}N_{15.80}, Eu_{0.01}Si_{11.60}Al_{0.40}O_{0.01}N_{15.99}, and Eu_{0.005}Si_{11.70}Al_{0.30}O_{0.03}N_{15.97}, for example.

While the average particle size of the divalent europium activated oxynitride green light emitting phosphor is not limited to a particular one, the average particle size measured by Blaine's method is preferably in a range of 3 to 10 µm, and more preferably in a range of 4 to 7 µm. If the average particle size of the oxynitride green light emitting phosphor is smaller than 3 µm, crystal growth is insufficient and the brightness could be considerably deteriorated. If the average particle size of the oxynitride green light emitting phosphor is larger than 10 µm, an abnormally grown large particle is likely to be generated, which is not appropriate for practical use.

### (C) Divalent europium activated oxynitride yellow light emitting phosphor that is α-type SiAlON

The divalent europium activated oxynitride yellow light emitting phosphor is substantially represented by general formula (C): MIII_{g}EuₕSiᵢAlⱼOₖNₗ.

In general formula (C), MIII is at least one element selected from Li (lithium), Na (sodium), K (potassium), Rb (rubidium), Cs (cesium), Mg, Ca, Sr, and Ba. In terms of properties, MIII is preferably at least one element selected from Li, Ca and Sr. In general formula (C), Eu represents europium, Si represents silicon, Al represents aluminum, O represents oxygen and N represents nitrogen.

In general formula (C), a value of "g" representing the proportion (concentration) of MIII satisfies the relation 0 < g ≤ 3.0, which is preferably 0.1 ≤ g ≤ 1.5. If a value of "g" is larger than 3.0, the brightness is considerably deteriorated. A value of "h" representing the proportion (concentration) ofEu in general formula (C) satisfies the relation 0.005 ≤ h ≤ 0.4. If a value of "h" is smaller than 0.005, a sufficient brightness cannot be obtained. If a value of "h" is larger than 0.4, the brightness is considerably deteriorated due to concentration quenching or the like. In terms of powder properties stability and host crystal homogeneity, a value of "h" in the formula above preferably satisfies the relation 0.01 ≤ h ≤ 0.2. In general formula (C), respective numerical values of "i" representing the proportion (concentration) of Si and "j" representing the proportion (concentration) of Al satisfy the relation i + j = 12, and respective numerical values of "k" representing the proportion (concentration) of O and "1" representing the proportion (concentration) ofN satisfy the relation k + 1= 16.

Specific examples of the divalent europium activated oxynitride yellow light emitting phosphor that is α-type SiAlON may include, but surely are not limited to, Ca_{0.70}Li_{0.05}Eu_{0.025}Si_{9.75}Al_{2.25}O_{0.75}N_{15.25}, Ca_{0.40}Mg_{0.10}Eu_{0.03}Si_{10.00}Al_{2.00}O_{1.10}N_{14.90}, Ca_{0.75}Eu_{0.01}Si_{9.75}Al_{2.25}O_{0.75}N_{15.25}, Ca_{0.50}Li_{0.10}Eu_{0.01}Si_{11.50}Al_{0.50}O_{0.20}N_{15.80}, Ca_{1.00}Sr_{0.10}Eu_{0.20}Si_{10.00}Al_{2.00}O_{0.30}N_{15.70}, and Ca_{0.35}Li_{0.20}Eu_{0.05}Si_{10.60}Al_{1.40}O_{1.25}N_{14.75}, for example.

While the average particle size of the divalent europium activated oxynitride yellow light emitting phosphor is not limited to a particular one, the average particle size measured by Blaine's method is preferably in a range of 4 to 12 µm, and more preferably in a range of 6 to 9 µm. If the average particle size of the oxynitride yellow light emitting phosphor is smaller than 4 µm, crystal growth is insufficient and the brightness could be considerably deteriorated. If the average particle size of the oxynitride yellow light emitting phosphor is larger than 12 µm, an abnormally grown large particle is likely to be generated, which is not suitable for practical use.

### (D) Trivalent cerium activated silicate green light emitting phosphor

The trivalent cerium activated silicate green light emitting phosphor is substantially represented by general formula (D): MIV₃(MV₁₋ₘCeₘ)₂(SiO₄)₃.

In general formula (D), MIV is at least one element selected from Mg, Ca, Sr, and Ba. In general formula (D), MV is at least one element selected from Al, Ga, In, Sc, Y, La, Gd, and Lu. In terms of properties, MIV is preferably at least one element selected from Ga, In, Sc, and Y, and is most preferably Sc. In general formula (D), Ce represents cerium, Si represents silicon and O represents oxygen.

In general formula (D), a value of "m" representing the proportion (concentration) of Ce satisfies the relation 0.005 ≤ m ≤ 0.5, which is preferably 0.01 ≤ m ≤ 0.2. If a value of "m" is smaller than 0.005, a sufficient brightness cannot be obtained. If a value of "m" is larger than 0.5, the brightness is considerably deteriorated due to concentration quenching or the like.

Specific examples of the trivalent cerium activated silicate green light emitting phosphor may include, but surely are not limited to, (Ca_{0.98}Mg_{0.02})₃(Sc_{0.90}Ce_{0.10})₂(SiO₄)₃, (Ca_{0.99} Mg _{0.01})₃(SC_{0.79}Y_{0.01}Ce_{0.20})₂(SiO₄)₃, (Ca_{0.97}Mg_{0.03})₃(SC_{0.85}Ce_{0.15})₂(SiO₄)₃, Ca₃(SC_{0.85}Ce_{0.15})₂(SiO₄)₃, (Ca_{0.9}Mg_{0.1})₃(Sc_{0.1})₃(Sc_{0.70}Ga_{0.15}Ce_{0.15})₂(SiO₄)₃, (Ca_{0.9}Mg_{0.1})₃(Sc_{0.80}Ce_{0.20})₂(SiO₄)₃, (Ca_{0.85}Mg_{0.15})₃(Sc_{0.15})₃(S_{0.50}Y_{0.20}Ce_{0.30})₂(SiO₄)₃, Ca₃(SC_{0.98}In_{0.01}Ce_{0.01})₂(SiO₄)₃, (Ca_{0.99}Sr_{0.01})₃(SC₀.₈₄.In_{0.10}Y₀.0₁Ce_{0.05})₂(SiO₄)₃, and (Ca_{0.95}Mg_{0.05})₃(Sc_{0.80}Ce_{0.20})₂(SiO₄)₃, for example.

While the average particle size of the trivalent cerium activated silicate green light emitting phosphor is not limited to a particular one, the average particle size measured by Blaine's method is preferably in a range of 5 to 12 µm, and more preferably in a range of 7 to 10 µm. If the average particle size of the silicate green light emitting phosphor is smaller than 5 µm, crystal growth is insufficient and the brightness could be considerably deteriorated. If the average particle size of the silicate green light emitting phosphor is larger than 12 µm, an abnormally grown large particle is likely to be generated, which is not suitable for practical use.

The light converter in the light emitting apparatus of the first aspect of the present invention includes the above-described (A) divalent europium activated nitride red light emitting phosphor as a red light emitting phosphor and, and includes, as a green light emitting phosphor, the above-described (B) divalent europium activated oxynitride green light emitting phosphor that is β-type SiAlON. In the light emitting apparatus of the first aspect of the present invention, the mixture ratio between the red light emitting phosphor and the green light emitting phosphor is not limited to a particular one. It is preferable to mix the red light emitting phosphor at a weight ratio in a range of 1 to 35% relative to the green light emitting phosphor, and it is more preferable to mix the red light emitting phosphor at a weight ratio in a range of 5 to 25% relative to the green light emitting phosphor.

In the case where the light emitting apparatus of the first aspect of the present invention includes the above-described (A) divalent europium activated nitride red light emitting phosphor as a red light emitting phosphor and includes, as a green light emitting phosphor, (B) divalent europium activated oxynitride green light emitting phosphor that is β-type SiAlON and has a narrow half width of the fluorescence spectrum, the light emitting apparatus emitting white light with favorable color reproducibility can be achieved. In a comparative example where the light emitting apparatus includes the above-described (A) divalent europium activated nitride red light emitting phosphor as a red light emitting phosphor and includes, as a yellow light emitting phosphor, (C) divalent europium activated oxynitride yellow light emitting phosphor that is α-type SiAlON, the light emitting apparatus emitting white light of warm white can be achieved. In a comparative example where the light emitting apparatus includes the above-described (A) divalent europium activated nitride red light emitting phosphor as a red light emitting phosphor and includes, as a green light emitting phosphor, (D) trivalent cerium activated silicate green light emitting phosphor having a wide half width of the emission spectrum, the light emitting apparatus emitting white light with high color rendition can be achieved.

A feature of the light emitting apparatus of the first aspect is that a forward current (IF) applied to the light emitting element is 25 mA or more. If the forward current applied to the light emitting element is less than 25 mA, the effect of favorable life property achieved by the light emitting apparatus of the first aspect of the present invention is not clearly exhibited. In the examples as described below, the light emitting apparatus was continuously operated under the condition of 35 mA and evaluated. In the cases where the light emitting apparatus is continuously operated under the conditions of 25 mA and 30 mA, similar effects can be obtained. Thus, the forward current applied to the light emitting element is preferably in a range of 25 to 35 mA.

A light emitting apparatus according to a comparative example basically includes a light emitting element of a gallium nitride (GaN) based semiconductor, and a light converter absorbing a part of primary light emitted from the light emitting element to emit secondary light having the longer wavelength than that of the primary light, and the light converter includes the above-described (C) divalent europium activated oxynitride yellow light emitting phosphor that is α-type SiAlON. In such a light emitting apparatus, a forward current (IF) applied to the light emitting element is also 25 mA or more. If the forward current applied to the light emitting element is less than 25 mA, the effect of favorable life property of the light emitting apparatus could not be clearly exhibited. In the examples as described below, the light emitting apparatus was continuously operated under the condition of 35 mA and evaluated. In the cases where the light emitting apparatus is continuously operated under the conditions of 25 mA and 30 mA, similar effects can be obtained. Thus, the forward current applied to the light emitting element is preferably in a range of 25 to 35 mA.

In the above-described light emitting apparatus of the first aspect of the present invention (this light emitting apparatus will be hereinafter referred to as "light emitting apparatus of the present invention", a gallium nitride (GaN) based semiconductor may preferably be used for the light emitting element that emits primary light with a peak wavelength in the blue region of 430 to 480 nm (more preferably 440 to 480 nm). If a light emitting element having a peak wavelength of less than 430 nm is used, contribution of the blue light component is smaller and the color rendering property is deteriorated, which could not be practical for use. If a light emitting element having a peak wavelength exceeding 480 nm is used, the brightness of white is lower, which could not be practical for use.

For the light emitting element used in the light emitting apparatus of the present invention as described above, a gallium nitride (GaN) based semiconductor emitting primary light having a peak wavelength in the blue to violet region of 380 to 420 nm (more preferably 390 to 405 nm) may be used. If a light emitting element having a peak wavelength of less than 380 nm is used, a resin used as a sealant is deteriorated to a degree that cannot be neglected, which could not be practical for use. If a light emitting element having a peak wavelength exceeding 420 nm is used, the brightness of a blue light emitting phosphor (as described later) is lower.

In the case where the light emitting element emitting the primary light having a peak wavelength of 380 to 420 nm as described above is used, the light converter in the light emitting apparatus of the present invention further includes, as a blue light emitting phosphor, (E) divalent europium activated halophosphate blue light emitting phosphor, or (F) divalent europium activated aluminate blue light emitting phosphor or (G) divalent europium and manganese activated aluminate blue light emitting phosphor.

### (E) Divalent europium activated halophosphate blue light emitting phosphor

The divalent europium activated halophosphate blue light emitting phosphor is substantially represented by general formula (E): (MVI, Eu)₁₀(PO₄)₆·Cl₂.

In general formula (E), MVI is at least one element selected from Mg, Ca, Sr, and Ba.

In general formula (E), Eu represents europium, P represents phosphorus, O represents oxygen, and Cl represents chlorine.

Specific examples of the divalent europium activated halophosphate blue light emitting phosphor may include, but surely are not limited to, (Sr_{0.70}Ba_{0.27}Ca_{0.01}EU_{0.02})₁₀(PO₄)₆·Cl₂, (Sr_{0.64}Ba_{0.30}Ca_{0.05}Eu_{0.01})₁₀(PO₄)₆·Cl₂, (Sr_{0.62}Ba_{0.35}Ca_{0.01}Eu_{0.02})₁₀(PO₄)₆·Cl₂, (Sr_{0.685}Ba_{0.250}Ca_{0.050}Eu_{0.015})₁₀(PO₄)₆·Cl₂, (Sr_{0.695}Ba_{0.275}Ca_{0.010}Eu_{0.020})₁₀(PO₄)₆·Cl₂, and (Sr_{0.70}Ba_{0.28}Ca_{0.01}Eu_{0.01})₁₀(PO₄)₆·Cl₂, for example.

While the average particle size of the divalent europium activated halophosphate blue light emitting phosphor is not limited to a particular one, the average particle size measured by Blaine's method is preferably in a range of 4 to 10 µm. If the average particle size of the halophosphate blue light emitting phosphor is smaller than 4 µm, crystal growth is insufficient and the brightness could be considerably deteriorated. If the average particle size of the halophosphate blue light emitting phosphor is larger than 10 µm, an abnormally grown large particle is likely to be generated, which is not suitable for practical use.

### (F) Divalent europium activated aluminate blue light emitting phosphor

The divalent europium activated aluminate blue light emitting phosphor is substantially represented by general formula (F): p(MVII, Eu)O·qAl₂O₃.

In general formula (F), MVII is at least one element selected from Mg, Ca, Sr, Ba, and Zn (zinc). In terms of properties, MVII is at least one element selected from Mg, Sr and Ba. In general formula (F), Eu represents europium, Al represents aluminum and O represents oxygen.

In general formula (F), p and q are numerical values satisfying the relations p > 0, q > 0 and 0.1 ≤ p/q ≤ 1.0. If p/q is smaller than 0.1 or larger than 1.0, the brightness is considerably deteriorated.

Specific examples of the divalent europium activated aluminate blue light emitting phosphor may include, but surely are not limited to, (Ba_{0.70}Eu_{0.30})MgAl₁₀O₁₇, (Ba_{0.65}Eu_{0.35})(Mg_{0.99}Mn_{0.01})Al₁₀O₁₇, (Ba_{0.55}Sr_{0.10}Eu_{0.35})MgAl₁₀O₁₇, (Ba_{0.80}Eu_{0.20})MgAl₁₀O₁₇, (Ba_{0.82}Sr_{0.03}Eu_{0.15})MgAl₁₀O₁₇, (Ba_{0.75}Sr_{0.15}Eu_{0.10})MgAl₁₀O₁₇, (Ba_{0.55}Sr_{0.60}Eu_{0.15})MgAl₁₀O₁₇, (Ba_{0.55}Sr_{0.30}Eu_{0.20})MgAl₁₀O₁₇, (Ba_{0.60}Sr_{0.20}Eu_{0.20})MgAl₁₀O₁₇, (Ba_{0.70}Sr_{0.15}Eu_{0.15})MgAl₁₀O₁₇, and (Ba_{0.30}Sr_{0.50}Eu_{0.20})MgAl₁₀O₁₇, for example.

While the average particle size of the divalent europium activated aluminate blue light emitting phosphor is not limited to a particular one, the average particle size measured by Blaine's method is preferably in a range of 2 to 7 µm. If the divalent europium activated aluminate blue light emitting phosphor having an average particle size smaller than 2 µm is used, crystal growth is insufficient and the brightness could be considerably deteriorated. If the divalent europium activated aluminate blue light emitting phosphor having an average particle size larger than 7 µm is used, an abnormally grown large particle is likely to be generated, which is not suitable for practical use.

### (G) Divalent europium and manganese activated aluminate blue light emitting phosphor

The divalent europium and manganese activated aluminate blue light emitting phosphor is substantially represented by general formula (G): p(MVII, Euᵣ, Mnₛ)O·qAl₂O₃.

In general formula (G), MVII is at least one element selected from Mg, Ca, Sr, Ba, and Zn, and is preferably at least one element selected from Mg, Sr and Ba in terms of properties. In general formula (G), Eu represents europium, Mn represents manganese, Al represents aluminum, and O represents oxygen.

In general formula (G), p and q are numerical values satisfying the relations p > 0, q > 0, and 0.1 ≤ p/q ≤ 1.0. If p/q is smaller than 0.1 or larger than 1.0, the brightness is considerably deteriorated. In general formula (G), r and s are numerical values satisfying the relations r > 0, s > 0, and 0.001 ≤ s/r ≤ 0.2. If s/r is smaller than 0.001, contribution of light emission by Mn is insufficient. If s/r is larger than 0.2, light emission by Mn is too strong, and the brightness of white is deteriorated.

Specific examples of the divalent europium and manganese activated aluminate blue light emitting phosphor may include, but surely are not limited to, (Ba_{0.74}Sr_{0.01}Eu_{0.25})(Mg_{0.999}Mn_{0.001})MgAl₁₀O₁₇, (Ba_{0.86}Eu_{0.14})(Mg_{0.99}Mn_{0.01})Al₁₀O₁₇, (Ba_{0.40}Sr_{0.50}Eu_{0.10})(Mg_{0.99}Mn_{0.01})Al₁₀O₁₇, (Ba_{0.50}Sr_{0.30}Eu_{0.20})(Mg_{0.999}Mn_{0.001})Al₁₀O₁₇, (Ba_{0.45}Sr_{0.40}Eu_{0.15})(Mg_{0.9985}Mn_{0.0015})Al₁₀O₁₇, and (Ba_{0.65}Sr_{0.20}Eu_{0.15})(Mg_{0.97}Mn_{0.03})Al₁₀O₁₇, for example.

While the average particle size of the divalent europium and manganese activated aluminate blue light emitting phosphor is not limited to a particular one, the average particle size measured by Blaine's method is preferably in a range of 2 to 7 µm If the divalent europium and manganese activated aluminate blue light emitting phosphor having an average particle size smaller than 2 µm is used, crystal growth is insufficient and the brightness could be considerably deteriorated. If the divalent europium and manganese activated aluminate blue light emitting phosphor having an average particle size larger than 7 µm is used, an abnormally grown large particle is likely to be generated, which is not suitable for practical use.

In the case where the light converter further includes the blue light emitting phosphor, the mixture ratio of the blue light emitting phosphor is not limited to a particular one. It is preferable to mix the blue light emitting phosphor at a weight ratio in a range of 0.2 to 50%, which is more preferably 10 to 40%, relative to the red light emitting phosphor and the green or yellow light emitting phosphor (in the case of the light emitting apparatus of the first aspect), or yellow light emitting phosphor (in the case of the light emitting apparatus of the second aspect).

The light emitting apparatus of the first aspect that is thus implemented with the light emitting element having a peak wavelength of 380 to 420 nm and the light converter further including a blue light emitting phosphor corresponds to a light emitting apparatus emitting white light with high color gamut and high color rendition with which the blue light emitting phosphor of the above-described (E) to (G) is combined so as to correct the blue spectrum, namely a light emitting apparatus combined with a phosphor for correcting the color rendition and color gamut of the blue region.

The above-described light emitting apparatus of the present invention includes two or more light emitting elements. If the light emitting apparatus includes one light emitting element and the forward current is 20 mA, the effect of favorable life property of the light emitting apparatus of the present invention could not be clearly exhibited. In the case where the light emitting apparatus includes two or more light emitting elements, the forward current applied to the light emitting elements is preferably 25 mA or more in total.

The light emitting apparatus of the present invention as described above efficiently absorbs the light emitted from the light emitting element, and thus white light with excellent life property, high reliability, high efficiency and high color rendition or high color gamut (NTSC ratio) can be obtained. Here, whether or not the life property is excellent in terms of brightness can be confirmed in the following way for example. In a constant temperature and humidity oven bath with a temperature of 60°C and a relative humidity of 90%, a forward current of 35 mA is applied and the light emitting apparatus is operated for 500 hours. Thereafter, a forward current of 20 mA is applied and the optical output (photocurrent) is measured. The initial value of the optical output and the value after 500 hours are compared with each other. Further, whether or not the life property is excellent in terms of chromaticity (x, y) can be confirmed by measuring the chromaticity by means of MCPD-2000 (manufactured by Otsuka Electronics Co., Ltd.) after the light emitting element is operated for 500 hours, similarly to the above-described method for confirmation in terms of the brightness, and comparing the initial value of the chromaticity with the value of the chromaticity after 500 hours.

As long as the light emitting apparatus of the present invention has the features as described above, the components, elements and the like other than those as described above are not particularly limited. Here, Fig. 1 is a cross section schematically showing a light emitting apparatus 1 in a preferred example of the present invention. Fig. 1 shows, as an example of the light emitting apparatus of the first aspect of the present invention, light emitting apparatus 1 where light emitting apparatus 1 basically includes a light emitting element 2 and a light converter 3, and light converter 3 includes a red light emitting phosphor 4 and a green light emitting phosphor 5. In Fig. 1, the example is shown where light converter 3 is implemented such that light emitting element 2, red light emitting phosphor 4 and green light emitting phosphor 5 are sealed in a sealant 6, and light converter 3 can absorb a part of primary light emitted from light emitting element 2 to emit secondary light whose wavelength is equal to or longer than the wavelength of the primary light. Fig. 2 is also a cross section schematically showing a light emitting apparatus 11 according to a comparative example. Fig. 2 shows light emitting apparatus 11 where light emitting apparatus 11 basically includes a light emitting element 2 and a light converter 12, and light converter 12 includes a yellow light emitting phosphor 13. In Fig. 2, the example is shown where light converter 12 is implemented such that light emitting element 2 and yellow light emitting phosphor 13 are sealed in a sealant 6, and light converter 12 can absorb a part of primary light emitted from light emitting element 2 to emit secondary light whose wavelength is equal to or longer than the wavelength of the primary light. As sealant 6, epoxy resin, silicone resin, urea resin, or the like that is a translucent resin material may be used. Sealant 6, however, is not limited to the above-referenced resins. Light converters 3, 12 may include, in addition to the above-described phosphors and sealant, any appropriate additive such as SiO₂, TiO₂, ZrO₂, Al₂O₃, and Y₂O₃ to the extent that does not deteriorate the effects of the present invention.

The above-described red light emitting phosphors, green or emitting phosphors and blue light emitting phosphors used for the light emitting apparatus of the present invention are well known, and these phosphors can be manufactured by any appropriate known method or are available in the form of products.

In the following, the present invention will be described in more detail with reference to examples and comparative examples. The present invention, however, is not limited to them.

### <Example 1>

Light emitting apparatus 1 of the example shown in Fig. 1 was produced in the following manner. For light emitting element 2, a gallium nitride (GaN) based semiconductor having a peak wavelength of 450 nm was used. For light converter 3, a red light emitting phosphor having the composition (Ca_{0.99}Eu_{0.01})AlSiN₃ (average particle size (Blaine's method): 6.2 µm) was used as red light emitting phosphor 4, and a green light emitting phosphor having the composition (Eu_{0.05}Si_{11.50}Al_{0.50}O_{0.05}N_{15.95} (β-type SiAlON) (average particle size (Blaine's method): 4.0 µm) was used as green or yellow light emitting phosphor 5. The green light emitting phosphor and the red light emitting phosphor were mixed at a ratio of 82:18 (percent by weight), and the mixture at a predetermined ratio was dispersed in a silicone resin to produce the light converter. The qualities (brightness and chromaticity) of the light emitting apparatus incorporating the produced light converter were evaluated.

For evaluation, the light emitting apparatus was first operated with a forward current (IF) of 20 mA, and the optical output (photocurrent) from the light emitting apparatus was measured as an initial value. Further, in a constant temperature and humidity oven bath with a temperature of 60°C and a relative humidity of 90%, the light emitting apparatus was operated with a forward current (IF) of 35 mA for 500 hours. After this, at room temperature (around 25°C), the light emitting apparatus was operated with a forward current (IF) of 20 mA and the optical output (photocurrent) from the light emitting apparatus was measured. Likewise, the chromaticity (x, y) was measured with MCPD-2000 (manufactured by Otsuka Electronics Co., Ltd.) by measuring the initial value of white light emitted from the light emitting apparatus and the value after 500 hours. The results are summarized in Table 1.

### <Comparative Example 1>

A light emitting apparatus was produced similarly to Example 1 except that a yellow light emitting phosphor having the composition 2(Sr_{0.80}Ba_{0.16}Ca_{0.01}Eu_{0.03})O·SiO₂ (average particle size: 8.5 µm) was used, and the qualities of the apparatus were evaluated. The results are summarized in Table 1.

**[Table 1]**

| | brightness (initial value) | brightness (after 500 hrs) | initial | | after 500 hrs | |
|---|---|---|---|---|---|---|
| | | | x | y | x | y |
| Example 1 | 98.8% | 90.3% | 0.307 | 0.321 | 0.306 | 0.319 |
| Comparative Example 1 | 100.0% | 74.5% | 0.308 | 0.321 | 0.288 | 0.286 |

It is seen from Table 1 that the light emitting apparatus of the present invention is remarkably excellent in life property (reliability) (variation of luminous intensity and chromaticity) relative to the conventional product.

### <Comparative Example 2>

Light emitting apparatus 1 of the example shown in Fig. 1 was produced in the following manner. The light emitting apparatus was produced similarly to Example 1 except for the followings. For light emitting element 2, a gallium nitride (GaN) based semiconductor having a peak wavelength of 460 nm was used. For light converter 3, a red light emitting phosphor having the composition (Ca_{0.96}Sr_{0.03}Eu_{0.01})AlSiN₃ (average particle size (Blaine's method): 5.7 µm) was used as red light emitting phosphor 4, and a green light emitting phosphor having the composition (Ca_{0.98}Mg_{0.02})₃(Sc_{0.90}Ce_{0.10})₂(SiO₄)₃ (average particle size (Blaine's method): 7.1 µm) was used as green or yellow light emitting phosphor 5. The green light emitting phosphor and the red light emitting phosphor were mixed at a ratio of 73.7:26.3 (percent by weight), and the mixture was used. The qualities of the produced light emitting apparatus were evaluated similarly to Example 1. The results are summarized in Table 2.

### <Comparative Example 3>

A light emitting apparatus was produced similarly to Example 1 except that a yellow light emitting phosphor having the composition 2(Sr_{0.72}Ba_{0.25}Ca_{0.01}Eu_{0.02})O·SiO₂ (average particle size: 8.8 µm) was used, and the qualities of the apparatus were evaluated. The results are summarized in Table 2.

**[Table 2]**

| | brightness (initial value) | brightness (after 500 hrs) | initial | | after 500 hrs | |
|---|---|---|---|---|---|---|
| | | | x | y | x | y |
| Comparative Example 2 | 97.9% | 88.6% | 0.296 | 0.308 | 0.294 | 0.305 |
| Comparative Example 3 | 100.0% | 74.0% | 0.297 | 0.309 | 0.276 | 0.273 |

It is seen from Table 2 that the light emitting apparatus of comparative example 2 is remarkably excellent in life property (reliability) (variation of luminous intensity and chromaticity) relative to the conventional product.

### <Example 2 and 3, Comparative Examples 4-17>

Light emitting apparatuses with various combinations of phosphors were produced similarly to Example 1, and the qualities of the apparatuses were evaluated. The compositions and average particle sizes of the phosphors as used and the peak wavelengths of the light emitting elements are shown in Table 3, and the results of evaluation are summarized in Table 4.

**[Table 3]**

| | phosphor composition | average particle size | peak wavelength of light emitting element |
|---|---|---|---|
| Comparative Example 4 | red: (Ca_{0.99}Eu_{0.01})(Al_{0.95}Ga_{0.05})SiN₃ | 5.5 µm | 445 nm |
| | yellow: Ca_{0.70}Li_{0.05}Eu_{0.025}Si_{9.75}Al_{2.25}O_{0.75}N_{15.25} | 4.3 µm | |
| Comparative Example 5 | (Sr_{0.900}8a_{0.070}Ca_{0.005}Eu_{0.025})O SiO₂ | 9.7 µm | 445 nm |
| Example 2 | red: (Ca_{0.985}Eu_{0.015})(Al_{0.99}In_{0.01})SiN₃ | 6.8 µm | 470 nm |
| | green: Eu_{0.01}Si_{11.80}Al_{0.20}O_{0.04}Ni_{15.96} | 3.8 µm | |
| Comparative Example 6 | 2(Sr_{0.77}Ba_{0.20}Eu_{0.03})O SiO₂ | 10.2 µm | 470 nm |
| Comparative Example 7 | red: (Ca_{0.98}Eu_{0.02})AlSiN₃ | 5.8 µm | 430 nm |
| | green: (Ca_{0.99}Mg_{0.01})₃(Sc_{0.79}Y_{0.01}Ce_{0.20})₂(SiO₄)₃ | 7.9 µm | |
| Comparative Example 8 | 2(Sr_{0.750}Ba_{0.205}Ca_{0.010}Eu_{0.035})O SiO₂ | 9.0 µm | 430 nm |
| Comparative Example 9 | red:(Ca_{0.99}Eu_{0.01})(Al_{0.99}Ga_{0.01})SiN₃ | 5.1 µm | 480 nm |
| | yellow: Ca_{0.40}Mig_{0.10}Eu_{0.03}Si_{10.00}Al_{2.00}O_{1.10}N_{14.90} | 5.7 µm | |
| Comparative Example 10 | 2(Sr_{0.900}Ba_{0.064}Ca_{0.001}Eu_{0.03}5)O SiO₂ | 8.8 µm | 480 nm |
| Comparative Example 11 | red: (Ca_{0.985}Eu_{0.015})AlSiN₃ | 5.1 µm | 460 nm |
| | green: (Ca_{0.97}Mg_{0.03})₃(Sc_{0.85}Ce_{0.15})₂(SiO₄)₃ | 5.7 µm | |
| Comparative Example 12 | 2(Sr_{0.90}oBa_{0.070}Ca_{0.005}Eu_{0.025})O SiO₂ | 9.6 µm | 460 nm |
| Example 3 | red: (Ca_{0.99}Eu_{0.01})AlSiN₃ | 5.3 µm | 455 nm |
| | green: Eu_{0.005}Si_{11.70}Al_{0.30}O_{0.03}N_{15.9}7 | 5.0 µm | |
| Comparative Example 13 | 2(Sr_{0.795}Ba_{0.176}Ca_{0.004}Eu_{0.025})O SiO₂ | 11.0 µm | 455 nm |
| Comparative Example 14 | yellow: Ca_{0.70}Li_{0.05}Eu_{0.025}Si_{9.75}Al_{2.25}O_{0.75}N_{15.25} | 4.3 µm | 445 nm |
| Comparative Example 15 | 2(Sr_{0.900}Ba_{0.070}Ca_{0.005}Eu_{0.025})O SiO₂ | 9.7 µm | 445 nm |
| Comparative Example 16 | yellow: Cao_{0.40}Mg_{0.10}Eu_{0.03}Si_{10.00}Al_{2.00}N_{14.90} | 5.7 µm | 480 nm |
| Comparative Example 17 | 2(Sr_{0.900}Ba_{0.064}Ca_{0.01}Eu_{0.035})O SiO₂ | 8.8 µm | 480 nm |

**[Table 4]**

| | brightness (initial value) | brightness (after 500 hrs) | initial | | after 500 hrs | |
|---|---|---|---|---|---|---|
| | | | x | y | x | y |
| Comparative Example 4 | 98.3% | 89.3% | 0.451 | 0.419 | 0.449 | 0.416 |
| Comparative Example 5 | 100.0% | 74.6% | 0.450 | 0.420 | 0.431 | 0.384 |
| Example 2 | 98.0% | 88.8% | 0.325 | 0.340 | 0.324 | 0.337 |
| Comparative Example 6 | 100.0% | 74.1% | 0.324 | 0.339 | 0.303 | 0.305 |
| Comparative Example 7 | 98.5% | 88.8% | 0.288 | 0.296 | 0.286 | 0.293 |
| Comparative Example 8 | 100.0% | 74.3% | 0.288 | 0.294 | 0.266 | 0.258 |
| Comparative Example 9 | 98.9% | 89.3% | 0.420 | 0.405 | 0.419 | 0.402 |
| Comparative Example 10 | 100.0% | 73.9% | 0.419 | 0.406 | 0.400 | 0.369 |
| Comparative Example 11 1 | 98.6% | 89.6% | 0.311 | 0.327 | 0.309 | 0.325 |
| Comparative Example 12 | 100.0% | 73.7% | 0.310 | 0.328 | 0.291 | 0.292 |
| Example 3 | 98.8% | 89.7% | 0.305 | 0.317 | 0.304 | 0.315 |
| Comparative Example 13 | 100.0% | 74.1% | 0.305 | 0.316 | 0.285 | 0.279 |
| Comparative Example 14 | 98.5% | 89.8% | 0.441 | 0.409 | 0.439 | 0.406 |
| Comparative Example 15 | 100.0% | 74.4% | 0.440 | 0.410 | 0.421 | 0.373 |
| Comparative Example 16 | 98.8% | 89.5% | 0.420 | 0.408 | 0.419 | 0.405 |
| Comparative Example 17 | 100.0% | 73.7% | 0.419 | 0.409 | 0.400 | 0.372 |

It is seen from Table 4 that the light emitting apparatuses of the present invention are remarkably excellent in life property (reliability) (variation of luminous intensity and chromaticity) relative to the conventional products.

### <Example 4>

A light emitting apparatus was produced similarly to Example 1 except for the followings. For the light emitting element, a gallium nitride (GaN) based semiconductor having a peak wavelength of 390 nm was used. For the light converter, a red light emitting phosphor having the composition (Ca_{0.99}Eu_{0.01})AlSiN₃ (average particle size (Blaine's method): 6.2 µm), a green light emitting phosphor having the composition Eu_{0.o5}Si_{11.50}Al_{0.50}O_{0.0}5N_{15.95} (β-type SiAlON) (average particle size (Blaine's method): 4.0 µm), and a blue light emitting phosphor having the composition (Ba_{0.70}Eu_{0.30})MgAl₁₀O₁₇ (average particle size (Blaine's method): 3.2 µm) were used. The green light emitting phosphor, the red light emitting phosphor and the blue light emitting phosphor were mixed at a ratio of 43.7:16.3:40.0 (percent by weight), and the mixture was used. The qualities of the produced light emitting apparatus were evaluated similarly to Example 1. The results are summarized in Table 5.

### <Comparative Example 18>

A light emitting apparatus was produced similarly to Example 1 except that a yellow light emitting phosphor having the composition 2(Sr_{0.80}Ba_{0.16}Ca_{0.01}Eu_{0.03})·SiO₂ (average particle size (Blaine's method): 8.5 µm) was used and that a gallium nitride (GaN) based semiconductor having a peak wavelength of 460 nm was used for the light emitting element, and the qualities of the apparatus were evaluated. The results are summarized in Table 5.

**[Table 5]**

| | brightness (initial value) | brightness (after 500 hrs) | initial | | after 500 hrs | |
|---|---|---|---|---|---|---|
| | | | x | y | x | y |
| Example 4 | 94.5% | 86.4% | 0.306 | 0.320 | 0.305 | 0.317 |
| Comparative Example 8 | 100.0% | 74.3% | 0.307 | 0.319 | 0.288 | 0.283 |

It is seen from Table 5 that the light emitting apparatus of the present invention is remarkably excellent in life property (reliability) (variation of luminous intensity and chromaticity) relative to the conventional product.

### <Examples 5 and 6, Comparative Examples 19-32>

Light emitting apparatuses with various combinations of phosphors were produced similarly to Example 1, and the qualities of the apparatuses were evaluated. The compositions and average particle sizes of the phosphors as used and the peak wavelengths of the light emitting elements are shown in Table 6, and the results of evaluation are summarized in Table 7.

**[Table 6]**

| | phosphor composition | average particle size | peak wavelength of light emitting element |
|---|---|---|---|
| Comparative Example 19 | red: (Ca_{0.96}Sr_{0.03}Eu_{0.01})AlSiN₃ | 5.7 µm | 410 nm |
| | green: (Ca_{0.98}Mg_{0.02})₃(Sc_{0.90}Ce_{0.10})₂(SiO₄)₃ | 7.1 µm | |
| | blue: (Ba_{0.65}Eu_{0.35})(Mg_{0.99}Mn_{0.01})Al₁₀O₁₇ | 3.7 µm | |
| Comparative Example 20 | 2(Sr_{0.72}8a_{0.25}Ca_{0.01}Eu_{0.02})O SiO₂ | 8.8 µm | 450 nm |
| Comparative Example 21 | red: (Ca_{0.99}Eu_{0.01})(Al_{0.95}Ga_{0.05})SiN₃ | 5.5 µm | 380 nm |
| | yellow: Ca_{0.70}Li_{0.05}Eu_{0.025}Si_{9.75}Al_{2.25}O_{0.75}N_{15.25} | 4.3 µm | |
| | blue: (Sr_{0.70}Ba_{0.27}Ca_{0.01}Eu_{0.02})₁₀(PO₄)₆ Cl₂ | 5.3 µm | |
| Comparative Example 22 | 2(Sr_{0.900}Ba_{0.070}Ca_{0.005}Eu_{0.025})O SiO₂ | 9.7 µm | 440 nm |
| Example 5 | red: (Ca_{0.985}Eu_{0.015})(Al_{0.99}In_{0.01})SiN₃ | 6.8 µm | 405 nm |
| | green: Eu_{0.01}Si_{11.80}Al_{0.20}O_{0.04}N_{15.96} | 3.8 µm | |
| | blue: (Ba_{0.55}Sr_{0.10}Eu_{0.35})MgAl₁₀O₁₇ | 3.3 µm | |
| Comparative Example 23 | 2(Sr_{0.77}Ba_{0.20}Eu_{0.03})O SiO₂ | 10.2 µm | 470 nm |
| Comparative Example 24 | red: (Ca_{0.98}Eu_{0.02})AlSiN₃ | 5.8 µm | 420 nm |
| | green: (Ca_{0.99}Mg_{0.01})₃(Sc_{0.79}Y_{0.01}Ce_{0.20})₂(SiO₄)₃ | 7.9 µm | |
| | blue: (Ba_{0.74}Sr_{0.01}Eu_{0.25})(Mg_{0.999}Mn_{0.01})MgAl₁₀O₁₇ | 4.1 µm | |
| Comparative Example 25 | 2(Sr_{0.750}Ba_{0.205}Ca_{0.010}Eu_{0.035})O SiO₂ | 9.0 µm | 455 nm |
| Comparative Example 26 | red: (Ca_{0.99}Eu_{0.01})(Al_{0.99}Ga_{0.01})SiN₃ | 5.1 µm | 395 nm |
| | yellow: Ca_{0.40}Mg_{0.10}Eu_{0.03}Si_{10.00}Al_{2.00}O_{1.10}N_{14.90} | 5.7 µm | |
| | blue: (Sr_{0.80}Ba_{0.15}Ca_{0.02}Eu_{0.03})₁₀(PO₄)₆ Cl₂ | 4.8 µm | |
| Comparative Example 27 | 2(Sr_{0.900}Ba_{0.064}Ca_{0.001}Eu_{0.03.5})O SiO₂ | 8.8 µm | 460 nm |
| Comparative Example 28 | red: (Ca_{0.985}Eu_{0.015})AlSiN₃ | 5.1 µm | 400 nm |
| | green: (Ca_{0.97}Mg_{0.03})₃(Sc_{0.85}Ce_{0.15})₂(SiO₄)₃ | 5.7 µm | |
| | blue: (Ba_{0.70}Sr_{0.15}Eu_{0.15})MgAl₁₀O₁₇ | 3.0 µm | |
| Comparative Example 29 | 2(Sr_{0.900}Ba_{0.070}Ca_{0.005}Eu_{0.025})O SiO₂ | 9.6 µm | 475 nm |
| Example 6 | red: (Ca_{0.99}Eu_{0.01})AlSiN₃ | 5.3 µm | 385 nm |
| | green: Eu_{0.005}Si_{11.70}Al_{0.03}N_{15.97} | 5.0 µm | |
| | blue: (Ba_{0.70}Sr_{0.05}Eu_{0.25})(Mg_{0.995}Mn_{0.005})MgAl₁₀O₁₇ | 3.4 µm | |
| Comparative Example 30 | 2(Sr_{0.795}8a_{0.176}Ca_{0.004}Eu_{0.025})O SiO₂ | 11.0 µm | 450 nm |
| Comparative Example 31 | yellow: Ca_{0.70}Li_{0.05}Eu_{0.025}Si_{9.75}Al_{2.25}O_{0.75}Ni_{15.25} | 4.3 µm | 380 nm |
| | blue: (Sr_{0.70}Ba_{0.27}Ca_{0.01}Eu_{0.02})₁₀(PO₄)₆ Cl₂ | 5.3 µm | |
| Comparative Example 32 | 2(Sr_{0.900}Ba_{0.070}Ca_{0.005}Eu_{0.025})O SiO₂ | 9.7 µm | 465 nm |

**[Table 7]**

| | brightness (initial value) | brightness (after 500 hrs) | initial | | after 500 hrs | |
|---|---|---|---|---|---|---|
| | | | x | y | x | y |
| Comparative Example 19 | 92.2% | 83.5% | 0.296 | 0.309 | 0.293 | 0.306 |
| Comparative Example 20 | 100.0% | 74.1% | 0.296 | 0.310 | 0.274 | 0.273 |
| Comparative Example 21 | 94.3% | 85.6% | 0.451 | 0.420 | 0.449 | 0.417 |
| Comparative Example 22 | 100.0% | 74.7% | 0.450 | 0.420 | 0.430 | 0.385 |
| Example 5 | 93.9% | 85.2% | 0.324 | 0.340 | 0.322 | 0.337 |
| Comparative Example 23 | 100.0% | 74.0% | 0.325 | 0.339 | 0.305 | 0.303 |
| Comparative Example 24 | 95.0% | 85.7% | 0.288 | 0.295 | 0.286 | 0.291 |
| Comparative Example 25 | 100.0% | 74.3 % | 0.288 | 0.296 | 0.266 | 0.259 |
| Comparative Example 26 | 94.8% | 85.6% | 0.420 | 0.405 | 0.418 | 0.402 |
| Comparative Example 27 | 100.0% | 73.7% | 0.421 | 0.405 | 0.400 | 0.368 |
| Comparative Example 28 | 95.5% | 86.8% | 0.311 | 0.326 | 0.309 | 0.323 |
| Comparative Example 29 | 100.0% | 73.9% | 0.310 | 0.326 | 0.290 | 0.291 |
| Example 6 | 94.8% | 86.1% | 0.304 | 0.316 | 0.302 | 0.313 |
| Comparative Example 30 | 100.0% | 74.4% | 0.305 | 0.317 | 0.285 | 0.280 |
| Comparative Example 31 | 94.3% | 85.5% | 0.440 | 0.410 | 0.438 | 0.407 |
| Comparative Example 32 | 100.0% | 74.5% | 0.440 | 0.409 | 0.420 | 0.374 |

It is seen from Table 7 that the light emitting apparatuses of the present invention are remarkably excellent in life property (reliability) (variation of luminous intensity and chromaticity) relative to the conventional products.

It should be construed that embodiments and examples disclosed herein are by way of illustration in all respects, not by way of limitation. It is intended that the scope of the present invention is defined by claims, not by the description above.

## Claims

1. A method for driving a light emitting apparatus (1), the light emitting apparatus comprising a light emitting element (2), and a light converter (3) absorbing a part of primary light emitted from the light emitting element (2) to emit secondary light having a longer wavelength than that of the primary light, said light converter (3) including a red light emitting phosphor (4) and a green light emitting phosphor (5),
said red light emitting phosphor (4) being a divalent europium activated nitride red light emitting phosphor represented by
general formula (A): (MI₁₋ₐEuₐ)MIISiN₃
where MI is at least one element selected from Mg, Ca, Sr, and Ba, MII is at least one element selected from Al, Ga, In, Sc, Y, La, Gd, and Lu, and 0.001 ≤ a ≤ 0.10, and
said green light emitting phosphor (5) being a divalent europium activated oxynitride green light emitting phosphor that is β-type SiAlON represented by
general formula (B): Eu_{b}Si_{c}Al_{d}OₑN_{f}
where 0.005 ≤ b ≤ 0.4, c + d = 12, and e + f = 16;
**characterized in that**
the light emitting element (2) is of a gallium nitride based semiconductor, and the method comprising the step;
applying a forward current to the light emitting element (2) in a range of 25 to 35 mA,
wherein the light emitting apparatus comprises at least two said light emitting elements (2).

2. The method according to claim 1, wherein
the primary light emitted from the light emitting element (2) has a peak wavelength of 430 to 480 nm.

3. The method according to claim 1, wherein
the primary light emitted from the light emitting element (2) has a peak wavelength of 380 to 420 nm, and
said light converter (3) further includes a blue light emitting phosphor that is a divalent europium activated halophosphate blue light emitting phosphor represented by
general formula (E): (MVI, Eu)₁₀(PO₄)₆·Cl₂
where MVI is at least one element selected from Mg, Ca, Sr, and Ba,
a divalent europium activated aluminate blue light emitting phosphor represented by
general formula (F): p(MVII, Eu)O·qAl₂O₃
where MVII is at least one element selected from Mg, Ca, Sr, Ba, and Zn, p > 0, q > 0, 0,1 ≤ p/q ≤ 1 .0, or
a divalent europium and manganese activated aluminate blue light emitting phosphor represented by
general formula (G): p(MVII, Euᵣ, Mnₛ)O·qAl₂O₃
where MVII is at least one element selected from Mg, Ca, Sr, Ba, and Zn, p > 0, q > 0, 0.1 ≤ p/q ≤ 1.0, r > 0, s > 0, and 0.001 ≤ s/r ≤ 0.2.

4. The method according to claim 1, wherein
a divalent europium activated nitride red light emitting phosphor is used that is represented by said general formula (A) where MII is at least one element selected from Al, Ga and In.

## Patentansprüche

1. Verfahren zum Steuern einer Licht emittierenden Vorrichtung (1), wobei die Licht emittierende Vorrichtung ein Licht emittierendes Element (2) und einen Lichtwandler (3) aufweist, der von dem Licht emittierenden Element (2) emittiertes Primärlicht teilweise absorbiert, um ein Sekundärlicht zu emittieren, das eine längere Wellenlänge als das Primärlicht besitzt, wobei der Lichtwandler (3) einen rotes Licht emittierenden Phosphor (4) und einen grünes Licht emittierenden Phosphor (5) umfasst,
wobei der rotes Licht emittierende Phosphor (4) ein mit divalentem Europium aktivierter rotes Licht emittierender Nitridphosphor ist, der dargestellt wird durch
die allgemeine Formel (A): (Ml₁₋ₐEuₐ)MIISiN₃
wobei MI zumindest ein Element ausgewählt aus Mg, Ca, Sr und Ba, MII zumindest ein Element ausgewählt aus Al, Ga, In, Sc, Y, La, Gd und Lu, und 0,001 ≤ a ≤ 0,10 ist, und
wobei der grünes Licht emittierende Phosphor (5) ein mit divalentem Europium aktivierter grünes Licht emittierender Oxinitridphosphor ist, der SiAlON vom β-Typ ist, dargestellt durch
die allgemeine Formel (B): Eu_{b}Si_{c}Al_{d}OₑN_{f}
wobei 0,005 ≤ b ≤ 0,4, c + d = 12 und e + f = 16 ist;
**dadurch gekennzeichnet, dass**
das Licht emittierende Element (2) ein auf Galliumnitrid basierender Halbleiter ist, und das Verfahren den folgenden Schritt aufweist:
Anlegen eines Durchlassstroms an das Licht emittierende Element (2) in einem Bereich von 25 bis 35 mA,
wobei die Licht emittierende Vorrichtung zumindest zwei der Licht emittierenden Elemente (2) aufweist.

2. Verfahren nach Anspruch 1, wobei
das von dem Licht emittierenden Element (2) emittierte Primärlicht eine Peak-Wellenlänge von 430 bis 480 nm besitzt.

3. Verfahren nach Anspruch 1, wobei
das von dem Licht emittierenden Element (2) emittierte Primärlicht eine Peak-Wellenlänge von 380 bis 420 nm besitzt, und
der Lichtwandler (3) des Weiteren einen blaues Licht emittierenden Phosphor umfasst, der
ein mit divalentem Europium aktivierter blaues Licht emittierender Halophosphatphosphor ist, dargestellt durch
die allgemeine Formel (E): (MVI, Eu)₁₀(PO₄)₆·Cl₂
wobei MVI zumindest ein Element ausgewählt aus Mg, Ca, Sr und Ba ist,
ein mit divalentem Europium aktivierter blaues Licht emittierender Aluminatphosphor ist, dargestellt durch
die allgemeine Formel (F): p(MVII, Eu)O·qAl₂O₃
wobei MVII zumindest ein Element ausgewählt aus Mg, Ca, Sr, Ba und Zn, p > 0, q > 0, 0,1 ≤ p/q ≤ 1,0 ist, oder
ein mit divalentem Europium und Mangan aktivierter blaues Licht emittierender Aluminatphosphor ist, dargestellt durch
die allgemeine Formel (G): p(MVII, Euᵣ, Mnₛ)O·qAl₂O₃ wobei MVII zumindest ein Element ausgewählt aus Mg, Ca, Sr, Ba, und Zn, p > 0, q > 0, 0,1 ≤ p/q ≤ 1,0, r > 0, s > 0 und 0,001 ≤ s/r ≤ 0,2 ist.

4. Verfahren nach Anspruch 1, wobei
ein mit divalentem Europium aktivierter rotes Licht emittierender Nitridphosphor verwendet wird, der durch die allgemeine Formel (A) dargestellt wird, wobei MII zumindest ein Element ausgewählt aus Al, Ga und In ist.

## Revendications

1. Procédé pour commander un appareil électroluminescent (1), l'appareil électroluminescent comprenant un élément électroluminescent (2) et un convertisseur de lumière (3) qui absorbe une partie de la lumière primaire émise à partir dudit élément électroluminescent (2), afin d'émettre une lumière secondaire qui présente une longueur d'onde plus longue que celle de la lumière primaire, ledit convertisseur de lumière (3) comprenant un matériau luminescent émetteur de lumière rouge (4) et un matériau luminescent émetteur de lumière verte (5),
ledit matériau luminescent émetteur de lumière rouge (4) étant un matériau luminescent émetteur de lumière rouge en nitrure activé par de l'europium bivalent représenté par
la formule générale (A) : (MI₁₋ₐEuₐ)MIISiN₃),
dans laquelle MI est au moins un élément choisi parmi Mg, Ca, Sr et Ba, MII est au moins un élément choisi parmi Al, Ga, In, Sc, Y, La, Gd et Lu, et 0,001 ≤ a ≤ 0,10, et
ledit matériau luminescent émetteur de lumière verte (5) étant un matériau luminescent émetteur de lumière verte en oxynitrure activé par de l'europium bivalent qui est un SiAlON du type représenté par
la formule générale (B) : Eu_{b}Si_{c}Al_{d}OₑN_{f},
dans laquelle 0,005 ≤ b ≤ 0,4, c + d = 12, et e + f = 16 ;
**caractérisé en ce que**
l'élément électroluminescent (2) est composé d'un semi-conducteur à base de nitrure de gallium, et le procédé comprenant l'étape :
d'application d'un courant direct à l'élément électroluminescent (2) dans une plage de 25 à 35 mA,
étant précisé que l'appareil électroluminescent comprend au moins deux éléments électroluminescents (2).

2. Procédé selon la revendication 1, étant précisé
que la lumière primaire émise à partir de l'élément électroluminescent (2) présente une longueur d'onde de pointe de 430 à 480 nm.

3. Procédé selon la revendication 1, étant précisé
que la lumière primaire émise à partir de l'élément électroluminescent (2) présente une longueur d'onde de pointe de 380 à 420 nm, et
que le convertisseur de lumière (3) comprend par ailleurs un matériau luminescent émetteur de lumière bleue qui est
un matériau luminescent émetteur de lumière bleue en halophosphate activé par de l'europium bivalent représenté par
la formule générale (E) : (MVI,Eu)₁₀(PO₄)₆•Cl₂, dans laquelle MVI est au moins un élément choisi parmi Mg, Ca, Sr et Ba,
un matériau luminescent émetteur de lumière bleue en aluminate activé par de l'europium bivalent représenté par
la formule générale (F) : p(MVII, Eu)O•qAl₂O₃, dans laquelle MVII est au moins un élément choisi parmi Mg, Ca, Sr, Ba et Zn, et p > 0, q > 0, 0,1 ≤ p/q ≤ 1,0, ou
un matériau luminescent émetteur de lumière bleue en aluminate activé par l'europium bivalent et le manganèse représenté par
la formule générale (G) : p(MVII, Euᵣ Mnₛ)O•qAl₂O₃ dans laquelle MVII est au moins un élément choisi parmi Mg, Ca, Sr, Ba et Zn, p > 0, q > 0, 0,1 ≤ p/q ≤ 1,0, r > 0, s > 0 et 0,001 ≤ s/r ≤ 0,2.

4. Procédé selon la revendication 1, étant précisé
qu'un matériau luminescent émetteur de lumière rouge en nitrure activé par l'europium bivalent est utilisé, qui est représenté par ladite formule générale (A) dans laquelle MII est au moins un élément choisi parmi Al, Ga et In.
